# EUROPÄISCHE PATENTSCHRIFT

(11) **EP 1 652 232 B1**
(45) Veröffentlichungstag und Bekanntmachung des Hinweises auf die Patenterteilung: **07.11.2007**
(21) Anmeldenummer: 04762426.7
(22) Anmeldetag: 20.07.2004
(51) Int. Cl.: H01L 23/373

(54) **Multichip-Schaltungsmodul und Verfahren zur Herstellung hierzu**
Multichip circuit module and method for the production thereof
Module circuit multipuce et son procédé de production

(30) Priorität: 07.08.2003 DE 10336171
(43) Veröffentlichungstag der Anmeldung: 03.05.2006
(73) Patentinhaber: Technische Universität, 38106 Braunschweig (DE)
(72) Erfinder: HEYEN, Johann, 81737 München (DE); JACOB, Arne, F., 38116 Braunschweig (DE)
(74) Vertreter: Gerstein, Hans Joachim
(86) Internationale Anmeldenummer: PCT/DE2004/001576
(87) Internationale Veröffentlichungsnummer: WO 2005/015632

(56) Entgegenhaltungen:
- WO-A-99/14806
- US-A- 5 983 974
- US-A1- 2003 128 080

## Beschreibung

Die Erfindung betrifft ein Multichip-Schaltungsmodul mit einer Hauptplatine, mindestens einem auf der Hauptplatine montierten und mit der Hauptplatine elektrisch kontaktierten Trägersubstrat und mindestens einem Halbleiterchip auf dem Trägersubstrat, der mit dem Trägersubstrat elektrisch kontaktiert ist, wobei
- das Trägersubstrat mindestens eine Kavität an einer Montageoberfläche zur Aufnahme mindestens eines Halbleiterchips hat,
- in der Kavität Anschlusskontakte für zugeordnete Bumps des Halbleiterchips vorgesehen sind,
- der mindestens eine Halbleiterchip in Flip-Chip-Technik mit den Bumps an den Anschlusskontakten montiert ist, und
- die Montageoberfläche des Trägersubstrates auf eine Kontaktoberfläche der Hauptplatine aufgebracht ist, wobei ein Füllmaterial zwischen der Kontaktoberfläche der Hauptplatine und der Montageoberfläche des Trägersubstrates vorgesehen ist.

Die Erfindung betrifft weiterhin ein Verfahren zur Herstellung derartiger Multichip-Schaltungsmodule.

Multichip-Schaltungsmodule sind hinreichend beispielsweise aus der US-A-2003/0128080, der DE 100 11 005 A1 und der DE 100 41 770 A1 bekannt. Vor allem Hochfrequenzschaltungen im Frequenzbereich bis 100 GHz werden in Form derartiger Multichip-Schaltungsmodule realisiert. Die Multichip-Schaltungsmodule bestehen hierbei aus einem Trägersubstrat, auf dem in Drahtbond- oder Flip-Chip-Technologie einzelne Halbleiterchips montiert werden. Geeignete Halbleiterchips können beispielsweise Millimeter Wave Monolithic Integrated Circuits MMIC sein. Das Trägersubstrat kann weiterhin passive Schaltungskomponenten, beispielsweise auf der Oberfläche oder in tieferen Ebenen des Trägersubstrates haben. Für den Hochfrequenzeinsatz kann das Trägersubstrat beispielsweise eine Mehrlagenkeramik sein, wie z. B. Low Temperature Cofired Ceramics LTCC.

Die Trägersubstrate mit den passiven und aktiven Schaltungskomponenten bilden wiederum Submodule, die auf einem weiteren Substrat, der Hauptplatine, zusammengefasst werden. Die Submodule sind elektrisch mit der Hauptplatine und somit auch untereinander kontaktiert.

Zur Kontaktierung der Trägersubstrate mit der Hauptplatine ist beispielsweise die Ball-Grid-Array BGA-Verbindungstechnik aus der DE 199 31 004 A1 bekannt.

Das Multichip-Schaltungsmodul wird anschließend mit dielektrischen Füllmaterialien verkapselt, wie in der DE 101 16 510 A1 offenbart ist, oder mit einem Metallgehäuse abgeschirmt, wie in der DE 100 59 688 A1 beschrieben ist.

In der EP 0 900 477 B1 ist ein elektronisches Bauelement mit Oberflächenwellenfiltern beschrieben, bei dem ein Trägersubstrat in Flip-Chip-Technik auf einer Hauptplatine montiert ist. Auf die dem Verbindungsbereich zwischen Trägersubstrat und Hauptplatine abgewandte Seite des Trägersubstrates bis hin zur Hauptplatine ist eine metallische Schutzschicht direkt aufgebracht, so dass ein dichter Verschluss zur Hauptplatine hin besteht.

Die Flip-Chip-Technik zur elektrischen Kontaktierung von Halbleiterchips auf ein Trägersubstrat bzw. eines Trägersubstrates auf eine Hauptplatine mit Hilfe von Bumps, die mit Anschlusskontakten verbunden werden, ist beispielsweise in der DE 100 41 695 A1, der DE 100 43 450 A1 und der DE 100 29 255 A1 beschrieben.

Zur Abschirmung der Multichip-Schaltungsmodule sind nachteilig zusätzliche Arbeitsschritte erforderlich.

In der DE 196 40 192 A1 ist ein Verfahren zur bumpfreien Flip-Chip-Montage von integrierten Schaltungen auf ein Substrat unter Verwendung anisotop leitfähiger Klebstoffe beschrieben, die Lotpartikel zur metallurgischen Verbindung zwischen integrierten Schaltkreis und Substrat beschrieben.

Die JP 2003174141 A1 offenbart ein Multichip-Schaltungsmodul, bei dem ein Halbleiterchip mit Bumps verbunden ist, die auf einer Ebene eines Trägersubstrats zu Anschlusskontakten in Kavitäten des Trägersubstrats geleitet sind. Die Montageoberfläche des Trägersubstrats ist mit zwischenliegenden Füllmaterial mit der Kontaktoberfläche einer Hauptplatine verbunden, so dass der Halbleiterchip eingekapselt ist. Die elektrische Kontaktierung des Trägersubstrats erfolgt über die Kavitäten zur Hauptplatine.

Aufgabe der Erfindung ist es, ein verbessertes Multichip-Schaltungsmodul mit einem kostengünstigeren und gleichzeitig höher integrierten, kompakteren Aufbau zu schaffen.

Die Aufgabe der Erfindung ist es weiterhin, ein verbessertes Verfahren zur Herstellung eines solchen Multichip-Schaltungsmoduls zu schaffen.

Die Aufgabe wird mit dem gattungsgemäßen Multichip-Schaltungsmodul erfindungsgemäß dadurch gelöst, dass das Trägersubstrat mehrlagig mit sich quer durch mehrere Lagen erstreckende Verbindungsleitungen ist. Die mehrlagige Strukturierung des Trägersubstrates wird vorzugsweise ausschließlich zur passiven Integration des Multichip-Schaltungsmoduls beispielsweise für Leitungsführungen, Filter und Biasnetzwerke genutzt.

Die Aufgabe wird mit dem gattungsgemäßen Verfahren weiterhin erfindungsgemäß gelöst durch die Schritte:
a) Einlassen des mindestens einen Halbleiterchips in für die Halbleiterchips an einer Montageoberfläche des Trägersubstrates vorgesehene Kavitäten;
b) Montieren des mindestens einen Halbleiterchips in Flip-Chip-Technik durch Kontaktierung von auf Anschlusskontakten in den Kavitäten aufliegenden Bumps der Halbleiterchips;
c) Auftragen einer Füllmaterialschicht auf die Kontaktoberfläche der Hauptplatine; und
d) Aufbringen des Trägersubstrates mit der Montageoberfläche auf die Kontaktoberfläche der Hauptplatine.

Im Vergleich zu den herkömmlichen Herstellungsverfahren von Multichip-Schaltungsmodulen ist die Anzahl der Arbeitsschritte bei der Aufbau- und Verbindungstechnik unter Anwendung von Standardtechnologien reduziert. Das Multichip-Schaltungsmodul lässt sich damit relativ preiswert herstellen und hat aufgrund der Kavitäten einen höher integrierten, kompakteren Aufbau.

Das Füllmaterial ist vorzugsweise ein anisotrop leitendes Material, wie beispielsweise eine anisotrop leitende Paste oder ein anisotrop leitender Film. Damit wird nicht nur eine Verkapselung und Abschirmung des Multichip-Schaltungsmoduls realisiert. Vielmehr werden im gleichen Arbeitsschritt zusätzlich alle Verbindungen zwischen dem Trägersubstrat und der Hauptplatine geschlossen. Durch den anisotropen Charakter des Füllmaterials ist eine Isolation benachbarter Leitungen gewährleistet.

Das Füllmaterial leitet dabei in Richtung der Auftragshöhe, d. h. in Richtung von der Hauptplatine zum Trägersubstrat. In der Fläche hingegen ist das anisotrope Füllmaterial isolierend.

Das Füllmaterial soll die Zwischenräume der Kavitäten nicht vollständig ausfüllen, um eine Benetzung der Oberfläche des Halbleiterchips und der Bumps mit Füllmaterial zu verhindern, so dass eine Veränderung der elektrischen Eigenschaften möglichst vermieden wird.

Die Erfindung wird nachfolgend anhand der beigefügten Zeichnungen beispielhaft näher erläutert. Es zeigen:
- Figur 1 -: Skizze eines Trägersubstrates mit Halbleiterchips in Querschnittsansicht;
- Figur 2-: Skizze des zum Aufsetzen auf eine Hauptplatine um 180° gedrehten Trägersubstrates mit elektrisch kontaktierten Halbleiterchips in Querschnittsansicht;
- Figur 3 -: Skizze eines Multichip-Schaltungsmoduls mit auf die Hauptplatine aufgesetztem Trägersubstrat in Querschnittsansicht.

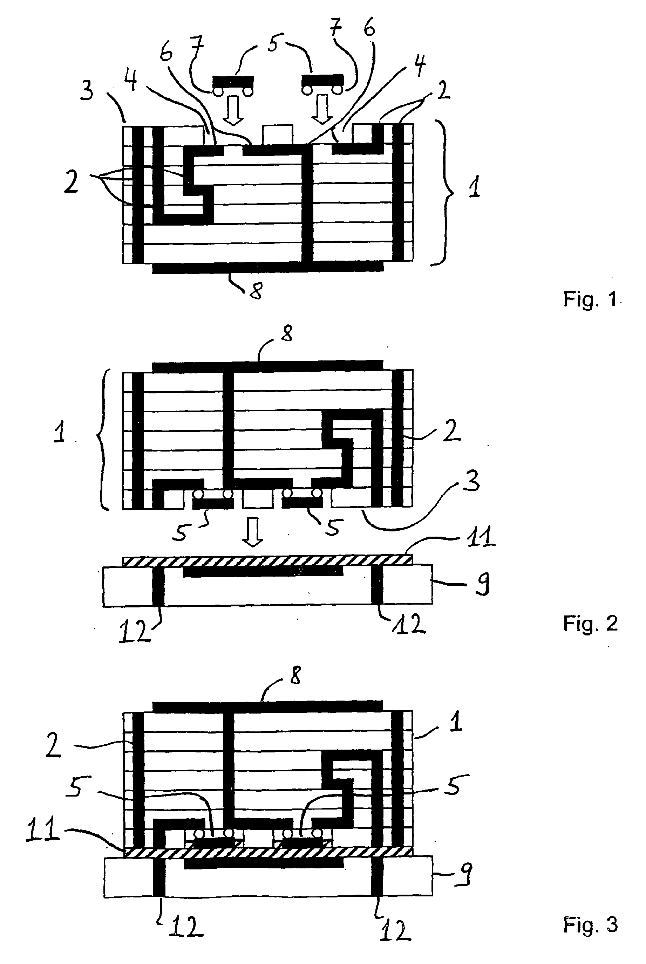

Die Figur 1 lässt eine Skizze eines mehrschichtigen Trägersubstrates 1 erkennen, das eine Vielzahl von Leiterbahnen 2 hat. An einer Montageoberfläche 3 des Trägersubstrates 1 sind Kavitäten 4 in Form von rechteckigen Aussparungen vorgesehen, in die Halbleiterchips 5 eingesetzt werden können. In den Kavitäten 4 sind entsprechend Anschlusskontakte 6 für Bumps 7 an der Unterseite der Halbleiterchips 5 vorgesehen. Mit Hilfe der Bumps 7 und der Anschlusskontakte 6 können die Halbleiterchips 5 in den Kavitäten 4 mit der bekannten Flip-Chip-Technik elektrisch kontaktiert werden. Als kostengünstige Realisierung mehrlagiger Trägersubstrate 1 bietet sich insbesondere im Zusammenhang mit der Herstellung von Kavitäten 4 die LTCC-Technologie (Low Temperature Co-fired Ceramics) an.

An der Unterseite des Trägersubstrates 1, die der Montageoberfläche 3 gegenüber liegt, ist eine planare Antennenanordnung 8, z. B. eine Patch-Antenne vorgesehen. Eine solche Konstruktion ist nunmehr möglich, da das Trägersubstrat 1 mit der Montageoberfläche 3 auf eine Hauptplatine montiert werden kann.

Bei den vertikalen Leiterbahnen 2 handelt es sich um sich quer durch mehrere Lagen des Trägersubstrates 1 erstreckende Verbindungsleitungen für HF- und DC-Signale. Die Leiterbahnen 2 können bspw. aus mindestens einem Leiter und ggf. mindestens einer zusätzlichen abschirmenden Durchführung bestehen. Die vertikale Leitungsführung kann auch in Hohlleitertechnik ausgeführt werden, wobei die vertikalen Durchkontaktierungen die leitenden Wände eines Hohlleiters bilden.

Die Figur 2 lässt den Verfahrensschritt des Zusammenfügens des Trägersubstrates 1, das um 180° in Bezug auf das in der Figur 1 dargestellte Trägersubstrat 1 gedreht ist, auf eine Hauptplatine 9 erkennen.

Auf der Kontaktoberfläche 10 der Hauptplatine 9 ist ein Füllmaterial 11 in Form eines anisotrop leitenden Films, einer anisotrop leitenden Paste oder einer isotrop leitenden Klebeschicht aufgetragen.

Das Trägersubstrat 1 wird nunmehr mit der Montageoberfläche 3 auf die Kontaktoberfläche 10 mit dem Füllmaterial 11 gepresst. Dabei sind die Halbleiterchips 5 in Flip-Chip-Technik bereits elektrisch mit dem Trägersubstrat 1 kontaktiert. Die Leiterbahnen 2 zur elektrischen Kontaktierung der Halbleiterchips sind durch das mehrschichtige Trägersubstrat 1 an die Montageoberfläche 3 geführt und werden mit entsprechenden Leiterbahnen 12 in der Hauptplatine 9 elektrisch verbunden, wenn das Trägersubstrat 1 mit der Hauptplatine 9 durch das Füllmaterial 11 verklebt ist.

Die Figur 3 lässt ein entsprechendes fertiges Multichip-Schaltungsmodul mit Trägersubstrat 1 und Hauptplatine 9 im zusammengefügten Zustand erkennen. Durch den Einsatz von anisotrop leitendem Füllmaterial 11, das in Richtung der Schichtdicke des Füllmaterials 11, d. h. in Richtung von Trägersubstrats 1 zur Hauptplatine 9 leitend und in Richtung der Fläche des Füllmaterials 11 isolierend ist, wird automatisch eine elektrische Verbindung der Leiterbahnen 2 und 12 hergestellt. Bei isotrop leitendem Füllmaterial werden Leiterbahnen 2, 12 an der Montageoberfläche 3 kurzgeschlossen, so dass keine Leitungsführung an der Montageoberfläche 3 vorgesehen werden sollte. Kapselung und Wärmeableitung ist jedoch nach wie vor gegeben.

Durch die im Vergleich zu herkömmlichen Multichip-Schaltungsmodulen umgekehrte Befestigungsweise des Trägersubstrates 1 auf die Hauptplatine 9 mit der die Halbleiterchips 5 beinhaltenden Montageoberfläche 3 wird in einem Arbeitsschritt eine Verkapselung erreicht, die die Hochfrequenzeigenschaft des Multichip-Schaltungsmoduls jedoch nicht beeinflusst. Zudem wird die in den Halbleiterchips 5 erzeugte Verlustwärme unmittelbar an die Hauptplatine 9 abgeführt, so dass zusätzliche platzraubende Durchkontaktierungen zur Abfuhr von Verlustwärme nicht erforderlich sind.

Durch Auswahl der Schichtdicke des Füllmaterials 11 derart, dass beim Absetzen des Trägersubstrates 1 mit Standard-Positioniergeräten ein komplettes Füllen der Zwischenräume der Kavitäten 4 vermieden wird, kann eine Versiegelung der Halbleiterchips erreicht werden, ohne dass die Chip-Oberfläche mit Bumps 7 und Füllmaterial 11 benetzt werden. Nach dem abschließenden Aushärten des Füllmaterials 11 wird eine dauerhafte störungsfreie Verkapselung und Abschirmung sichergestellt.

Die Hauptplatine 9 kann je nach Auswahl des Füllmaterials 11 und der gewünschten Anwendung ein ein- oder mehrlagiges Substratmaterial oder eine Metallplatte sein.

Wenn lediglich eine störungsfreie Kapselung und eine gute thermische Abfuhr erzielt werden soll, bietet sich eine Metallplatte an. Für komplexere Anordnungen kann die Hauptplatine 9 ebenfalls eine beliebige Kombination aus mehrlagigem Substrat und ggf. strukturierter Metallplatte sein.

Durch Herstellung des Multichip-Schaltungsmoduls in einer geeigneten Atmos-phäre kann in den Kavitäten 4 nicht nur Luft, sondern ein beliebiges (Schutz-) Gas eingeschlossen werden.

## Patentansprüche

1. Multichip-Schaltungsmodul mit einer Hauptplatine (9), mindestens einem auf der Hauptplatine (9) montierten und mit der Hauptplatine (9) elektrisch kontaktierten Trägersubstrat (1), und mit mindestens einem Halbleiterchip (5) auf dem Trägersubstrat (1), der mit dem Trägersubstrat (1) elektrisch kontaktiert ist, wobei
- das Trägersubstrat (1) mindestens eine Kavität (4) an einer Montageoberfläche zur Aufnahme mindestens eines Halbleiterchips (5) hat,
- in der Kavität (4) Anschlusskontakte (6) für zugeordnete Bumps (7) des Halbleiterchips (5) vorgesehen sind,
- der mindestens eine Halbleiterchip (5) in Flip-Chip-Technik mit den Bumps (7) an den Anschlusskontakten (6) montiert ist, und
- die Montageoberfläche (3) des Trägersubstrates (1) auf eine Kontaktoberfläche (10) der Hauptplatine (9) aufgebracht ist, wobei ein Füllmaterial (11) zwischen der Kontaktoberfläche (10) der Hauptplatine (9) und der Montageoberfläche (3) des Trägersubstrates (1) vorgesehen ist, das Trägersubstrat (1) mehrlagig mit sich quer durch mehrere Lagen erstreckende Leiterbahnen (2) ist und das Füllmaterial (11) die Halbleiterchips (5) in den Kavitäten (4) rückseitig kontaktiert, ohne die Anschlusskontakte (6) und Bumps (7) zu umschließen.

2. Multichip-Schaltungsmodul nach Anspruch 1, **dadurch gekennzeichnet, dass** das Füllmaterial (11) ein anisotrop leitendes Material, beispielsweise eine anisotrop leitende Paste oder ein anisotrop leitender Film ist.

3. Multichip-Schaltungsmodul nach Anspruch 1 oder 2, **dadurch gekennzeichnet, dass** das Füllmaterial (11) die Zwischenräume der Kavitäten (4) nicht vollständig ausfüllt.

4. Multichip-Schaltungsmodul nach einem der vorhergehenden Ansprüche, **dadurch gekennzeichnet, dass** Leiterbahnen (2) des Trägersubstrates (1) an die Montageoberfläche (3) geführt und mit Leiterbahnen (12) der Hauptplatine (9) elektrisch und mechanisch zur gleichzeitigen Signalführung, Wärmeableitung, Kapselung und Abschirmung verbunden sind.

5. Multichip-Schaltungsmodul nach einem der vorhergehenden Ansprüche, **gekennzeichnet durch** eine planare Antennenanordnung (8) auf der Unterseite des Trägersubstrates (1), die der Montageoberfläche (3) gegenüberliegt.

6. Multichip-Schaltungsmodul nach einem der vorhergehenden Ansprüche, **dadurch gekennzeichnet, dass** das Trägersubstrat (1) eine Mehrlagenkeramik, insbesondere eine Low Temperature Co-fired Ceramic (LTCC) ist.

7. Verfahren zur Herstellung von Multichip-Schaltungsmodulen nach einem der vorhergehenden Ansprüche mit den Schritten:
a) Einlassen des mindestens einen Halbleiterchips (5) in für die Halbleiterchips (3) an einer Montageoberfläche (3) des Trägersubstrates (1) vorgesehene Kavitäten (4);
b) Montieren des mindestens einen Halbleiterchips (5) in Flip-Chip-Technik durch Kontaktierung von auf Anschlusskontakten (6) in den Kavitäten (4) aufliegenden Bumps (7) der Halbleiterchips (5);
c) Auftragen einer Füllmaterialschicht (11) auf die Kontaktoberfläche (10) der Hauptplatine (9); und
d) Aufbringen des Trägersubstrates (1) mit der Montageoberfläche (3) auf die Kontaktoberfläche (10) der Hauptplatine (9).

8. Verfahren nach Anspruch 7 **gekennzeichnet durch** Auftragen eines anisotrop leitenden Füllmaterials (11), insbesondere einer Paste oder eines Films, als Füllmaterial (11) auf die Kontaktoberfläche.

9. Verfahren nach Anspruch 7 oder 8, **gekennzeichnet durch** Auftragen der Füllmaterialschicht (11) in einer derart angepassten Schichtstärke, dass Zwischenräume der Kavitäten (4) mit dem Füllmaterial (11) nicht vollständig ausgefüllt werden.

10. Verfahren nach einem der Ansprüche 7 bis 9, **gekennzeichnet durch** elektrisches Verbinden von sich quer **durch** mehrere Lagen des Trägersubstrates (1) erstreckende Leiterbahnen (2), die an die Montageoberfläche (3) geführt sind, mit Leiterbahnen (12) der Hauptplatine (9).

11. Verfahren nach einem der Ansprüche 7 bis 10, **gekennzeichnet durch** Herstellung in einer Gasatmosphäre zum Einschließen von Gas in die Kavitäten (4).

## Claims

1. A multichip circuit module having a main circuit board (9), at least one carrier substrate (1) which is mounted on the main circuit board (9) and which is in electrical contact with the main circuit board (9), and at least one semiconductor chip (5) on the carrier substrate (1) which is in electrical contact with the carrier substrate (1),
- the carrier substrate (1) having at least one cavity (4) on a mounting surface to accommodate at least one semiconductor chip (5),
- connecting contacts (6) for associated bumps (7) of the semiconductor chip (5) being provided in the cavity (4),
- the at least one semiconductor chip (5) being mounted on the connecting contacts (6) by using the bumps (7) in the flip-chip technique,
and
- the mounting surface (3) of the carrier substrate (1) being applied to a contact surface (10) of the main circuit board (9), a filling material (11) being provided between the contact surface (10) of the main circuit board (9) and the mounting surface (3) of the carrier substrate (1), the carrier substrate (1) having many layers with conductor tracks (2) extending transversely through a plurality of layers, and the filling material (11) makes contact with the rear of the semiconductor chips (5) in the cavities (4) without enclosing the connecting contacts (6) and bumps (7).

2. The multichip circuit module as claimed in claim 1, **characterized in that** the filling material (11) is an anisotropically conductive material, for example an anisotropically conductive paste or an anisotropically conductive film.

3. The multichip circuit module as claimed in claim 1 or 2, **characterized in that** the filling material (11) does not fill the interspaces of the cavities (4) completely.

4. The multichip circuit module as claimed in one of the preceding claims, **characterized in that** conductor tracks (2) of the carrier substrate (1) are led to the mounting surface (3) and are connected electrically and mechanically to conductor tracks (12) of the main circuit board (9) for the simultaneous carrying of signals, dissipation of heat, encapsulation and shielding.

5. The multichip circuit module as claimed in one of the preceding claims, **characterized by** a planar antenna arrangement (8) on the underside of the carrier substrate (1), which is opposite the mounting surface (3).

6. The multichip circuit module as claimed in one of the preceding claims, **characterized in that** the carrier substrate (1) is a multilayer ceramic, in particular a low-temperature co-fired ceramic (LTCC).

7. A method for the production of multichip circuit modules as claimed in one of the preceding claims, having the following steps:
a) letting the at least one semiconductor chip (5) into cavities (4) provided for the semiconductor chips (3) on a mounting surface (3) of the carrier substrate (1);
b) mounting the at least one semiconductor chip (5) in the flip-chip technique by making contact with bumps (7) of the semiconductor chips (5) resting on connecting contacts (6) in the cavities (4);
c) applying a layer of filling material (11) to the contact surface (10) of the main circuit board (9); and
d) applying the carrier substrate (1) having the mounting surface (3) to the contact surface (10) of the main circuit board (9).

8. The method as claimed in claim 7, **characterized by** application of an anisotropically conductive filling material (11), in particular a paste or a film, to the contact surface as the filling material (11).

9. The method as claimed in claim 7 or 8, **characterized by** application of the filling material layer (11) in a layer thickness which is matched in such a way that interspaces of the cavities (4) are not filled completely with the filling material (11).

10. The method as claimed in one of claims 7 to 9, **characterized by** electrical connection of conductor tracks (2), which extend transversely through a plurality of layers of the carrier substrate (1) and are led to the mounting surface (3), to conductor tracks (12) of the main circuit board (9).

11. The method as claimed in one of claims 7 to 10, **characterized by** production in a gas atmosphere in order to enclose gas in the cavities (4).

## Revendications

1. Module de circuit multipuce comportant une platine principale (9), au moins un substrat de support (1), monté sur la platine principale (9) et en contact électrique avec la platine principale (9), et avec au moins une puce semi-conductrice (5) sur le substrat de support (1) qui est en contact électrique avec le substrat de support (1),
- le substrat de support (1) ayant au moins une cavité (4) sur une surface de montage pour recevoir au moins une puce semi-conductrice (5),
- des contacts de connexion (8) étant prévus dans la cavité (4) pour des plots (7) correspondants de la puce semi-conductrice (5),
- ladite au moins une puce semi-conductrice (5) étant montée avec les plots (7) sur les contacts de connexion (6) selon la technique Flip-Chip et,
- la surface de montage (3) du substrat de support (1) étant appliquée sur une surface de contact (10) de la platine principale (9), une matière de remplissage (11) étant prévue entre la surface de contact (10) de la platine principale (9) et la surface de montage (3) du substrat de support (1), le substrat de support (1) ayant plusieurs couches à travers lesquelles s'étendent transversalement des pistes conductrices (2) en plusieurs couches, et la matière de remplissage (11) étant en contact avec l'arrière des puces semi-conductrices (5) dans les cavités (4), sans entourer les contacts de connexion (6) et les plots (7).

2. Module de circuit multipuce selon la revendication 1, **caractérisé en ce que** la matière de montage (11) est une matière conductrice anisotrope, par exemple une pâte conductrice anisotrope ou un film conducteur anisotrope.

3. Module de circuit multipuce selon la revendication 1 ou 2, **caractérisé en ce que** la matière de remplissage (11) ne remplit pas complètement les espaces intermédiaires des cavités (4).

4. Module de circuit multipuce selon l'une des revendications précédentes, **caractérisé en ce que** les pistes conductrices (2) du substrat de support sont guidées vers la surface de montage (3) et sont reliées électriquement et mécaniquement avec des pistes conductrices (12) de la platine principale (9) pour réaliser simultanément un guidage de signal, une évacuation de la chaleur, une encapsulation et un blindage.

5. Module de circuit multipuce selon l'une des revendications précédentes, **caractérisé par** une disposition plane d'antenne (8) sur la face inférieure du substrat de support (1) qui est opposée à la surface de montage (3).

6. Module de circuit multipuce selon l'une des revendications précédentes, **caractérisé en ce que** le substrat de support (1) est une céramique en plusieurs couches, en particulier une céramique basse température « Co-Fired » (LTCC).

7. Procédé pour fabriquer des modules de circuits multipuce selon l'une des revendications précédentes comprenant les étapes suivantes :
a/ introduction de ladite au moins une puce semi-conductrice (5) dans l'une des cavités (4) prévues pour les puces semi-conductrices (3) sur une surface de montage (3) du substrat de support (1),
b/ montage de ladite au moins une puce semi-conductrice (5) selon la technique Flip-Chip par mise en contact par recouvrement des contacts de connexion (6) dans les cavités (4) par les plots (7) des puces semi-conductrices (5),
c/ application d'une couche de matière de remplissage (11) sur la surface supérieure de contact (10) de la platine principale (9), et
d/ application de la surface de montage (3) du substrat de support (1) sur la surface supérieure de contact (10) de la platine principale (9).

8. Procédé selon la revendication 7, **caractérisé par** l'application d'une matière de remplissage (11) conductrice anisotrope, en particulier une pâte ou un film, en tant que matière de remplissage (11) sur la surface supérieure de contact.

9. Procédé selon la revendication 7 ou 8, **caractérisé par** l'application d'une couche de remplissage (11) dans une épaisseur adaptée de telle sorte que des espaces intermédiaires des cavités (4) ne soient pas entièrement remplis par la matière de remplissage (11).

10. Procédé selon l'une des revendications 7 à 9, **caractérisé par** la liaison électrique de pistes conductrices (2) qui s'étendent transversalement à travers plusieurs couches du substrat de support (2), qui sont guidées vers la surface de montage (3), avec des pistes conductrices (12) de la platine principale (9).

11. Procédé selon l'une des revendications 7 à 9, **caractérisé par** la formation d'une atmosphère gazeuse pour l'introduction de gaz dans les cavités (4).
